# EUROPÄISCHE PATENTANMELDUNG

(11) **EP 4 686 954 A1**
(43) Veröffentlichungstag der Anmeldung: **04.02.2026**
(21) Anmeldenummer: 24192440.6
(22) Anmeldetag: 01.08.2024
(51) Int. Cl.: G01R 31/34, G01R 31/72

(54) **TESTEN EINER ISOLIERUNG EINES LEITERSEGMENTS FÜR EINE ELEKTRISCHE MASCHINE, BEREITSTELLEN VON LEITERSEGMENTE MIT EINEM TEST SOWIE TESTVORRICHTUNG ZUM DURCHFÜHREN DES TESTENS**

(71) Anmelder: Grob-Werke GmbH & Co. KG, 87719 Mindelheim (DE)
(72) Erfinder: Greiner, Markus, 87757 Kirchheim (DE); Wimbauer, Patrick, 87700 Memmingen (DE); Sinner, Michael, 87730 Bad Grönenbach (DE)
(74) Vertreter: KASTEL Patentanwälte PartG mbB

(57) **Zusammenfassung**

Die Erfindung betrifft ein Verfahren zum Testen einer Isolierung (42) eines Leitersegments (10) für eine elektrische Maschine auf Fehlstellen, mit:
a) elektrisches Verbinden eines Leitersegmentanschlusses (46) des Leitersegments (10) mit einem Testanschluss (44),
c) relatives Bewegen des Leitersegments (10) und eines Testkontakts (32), um den zu testenden Bereich (48) der Isolierung (42) mit dem Testkontakt (32) abzufahren und
d) Überprüfen, ob während Schritt c) eine elektrische Verbindung zwischen dem Testanschluss (44) und dem Testkontakt (32) besteht, um so auf eine Fehlstelle (14) der Isolierung (42) zu schließen.

Um Fehlstellen (14) auch bei höheren Geschwindigkeiten sicher zu erfassen und Fehldetektionen zu verringern oder zu vermeiden, weist das Verfahren weiter den vor oder während Schritt c) durchzuführenden Schritt:
b) kapazitives Aufladen des Leitersegments (10)
auf.

## Beschreibung

Die Erfindung betrifft ein Verfahren zum Testen einer Isolierung eines Leitersegments für eine elektrische Maschine auf Fehlstellen. Weiter betrifft die Erfindung ein Verfahren zum Bereitstellen von Leitersegmenten zur Herstellung von Hairpin-Statoren in industrieller Großserienfertigung, umfassend Durchführen eines solchen Testverfahrens. Weiter betrifft die Erfindung eine Testvorrichtung zum Testen einer Isolierung eines Leitersegments für eine elektrische Maschine auf Fehlstellen.

Die Erfindung liegt auf dem Gebiet der Herstellung von elektrischen Maschinen, insbesondere der industriellen Großserienfertigung von Statoren wie Hairpin-Statoren oder Wellenwicklungsstatoren. Ausführungsformen der Erfindung betreffen ein Verfahren und eine Vorrichtung zur Qualitätssicherung im Zuge der Bereitstellung von Leitersegmenten für elektrische Maschinen. Insbesondere finden Ausführungsbeispiele der Erfindung Verwendung auf dem Gebiet der Montagemaschinen für die Assemblierung von elektrischen Maschinen wie Elektromotoren.

Zum technologischen Hintergrund wird zunächst auf folgende, durch Bezugnahme hierin inkorporierte Literaturstellen verwiesen, aus denen Verfahren und Vorrichtungen hervorgehen, die bei der industriellen Großserienproduktion von Hairpin-Statoren Verwendung finden:
[1] DE 10 2018 103 926 A1
[2] DE 10 2018 102 914 A1
[3] DE 10 2018 106 980 A1
[4] DE 10 2018 106 978 A1
[5] DE 10 2018 108 656 A1
[6] WO 2019/161832 A1
[7] DE 10 2018 117 A1
[8] DE 10 2018 106 977 A1
[9] WO 2019/161846 A1
[10] WO 2018/233769 A1
[11] DE 10 2018 112 876 A1
[12] WO 2018/233771 A1
[13] EP 3 771 079 A1
[14] EP 3 771 078 A1
[15] EP 3 763 472 B1
[16] EP 3 797 918 A1
[17] WO 2021/160414 A1
[18] EP 3 905 494 A1
[19] WO 2022/096079 A1
[20] EP 4 239 898 B1
[21] Wikipedia "Hairpin technology", heruntergeladen am 23.05.2024 unter https://en.wikipedia.org/wiki/Hairpin_technology
[22] VDMA, Production Process of Hairpin stators, heruntergeladen am 23.05.2024 unter https://www.researchgate.net/publication/337363214_Produktionsprozess _eines_Hairpinstators
[23] US 11 018 482 B2

Weiter wird auf folgende Literaturstellen verwiesen, die die industrielle Großserienherstellung von Wellenwicklungsstatoren betreffen und die ebenfalls durch Bezugnahme inkorporiert werden:
[24] WO 2019/020148 A1
[25] WO 2020/187363 A1
[26] WO 2019/166060 A1
[27] WO 2019/166061 A1
[28] WO 2017/102892 A2
[29] DE 10 2020 130 647 A1
[30] EP 3 886 303 A1
[31] GB 1 027 777 A
[32] GB 639 069 A
[33] WO 2018/019970A1
[34] DE 10 2020 117 771 A1
[35] DE 10 2021 134 599 A1
[36] DE 10 2020 130 647 A1
[37] DE 10 2018 108 615 A1
[38] DE 10 2018 103 926 A1

Unter elektrischen Maschinen werden insbesondere Maschinen zum Umwandeln elektrischer Energie in Bewegungsenergie und Maschinen zum Umwandeln von Bewegungsenergie in elektrische Energie verstanden. Insbesondere sind darunter Elektromotoren und Generatoren zu verstehen. Bei der Erfindung geht es um Verfahren und Vorrichtungen, die im Rahmen einer industriellen Großserienproduktion von Statoren oder dergleichen Bauteilen für solche elektrische Maschinen Verwendung finden, welche elektrische Maschinen insbesondere als Fahrmotoren für elektrisch betriebene Fahrzeuge eingesetzt werden sollen. Genauer geht es bei einigen Ausführungsformen der Erfindung um Verfahren und Vorrichtungen zur Verwendung bei der Herstellung von Hairpin-Statoren oder mit anderen Worten bei der Herstellung von Statoren nach der sogenannten Hairpin-Technologie, wie sie insbesondere in den Literaturstellen [21] oder [22] erläutert wird. Dabei werden zunächst einzelne Leiterabschnitte bereitgestellt, in U-förmig oder haarnadelförmig geformt - diese gebogenen Leiterabschnitte werden auch Hairpins oder einfach Pins genannt - und einzeln oder zu Kränzen vereinigt in ein Blechpaket eines Stators eingefügt, so dass auf einer axialen Seite die U-Biegungen (Wickelköpfe genannt) liegen und auf der anderen Seite Leiterenden vorstehen. Zum Bilden der Spulenwicklung werden die herausstehenden Leiterenden gebogen und zu Paaren verspannt und miteinander verschweißt. Verfahren und Vorrichtungen gemäß Ausführungsformen der Erfindung sind aber auch bei der Herstellung, insbesondere Großserienproduktion von Wellenwicklungsstatoren verwendbar, wie in den Literaturstellen [24] bis [38] näher beschrieben und gezeigt.

Sowohl bei der Hairpin-Technologie als auch bei der Wellenwicklungstechnologie werden zur Herstellung von Spulenwicklungen von Bauteilen elektrischer Maschinen Leitersegmente, insbesondere Drahtsegmente, beispielsweise aus Kupfer, vorzugsweise mit Rechteckquerschnitt mit Isolierung bereitgestellt. Insbesondere wird hierzu ein außen mit einer elektrischen Isolierungsschicht - insbesondere polymere Isolierungsschicht von einer Rolle abgewickelt. Von dem Endlosleiter vereinzelte Leitersegmente werden entsprechend der gewünschten Form gebogen, um daraus die Spulenwicklung herzustellen.

Wenngleich das Verbiegen möglichst schonend erfolgt, kann es vorkommen, dass insbesondere nach dem Biegen Beschädigungen an der Isolierung auftreten. Werden Leitersegmente mit fehlerhafter Isolierung in ein Bauteil verbaut, kann dies unter Umständen zu einem Ausschuss-Bauteil führen. Es ist daher vorteilhaft, die Isolierung der Leitersegmente vor deren Einbau auf Schadstellen zu überprüfen.

Ein Testverfahren gemäß Oberbegriff des Anspruchs 1 und eine Testvorrichtung gemäß Oberbegriff des Nebenanspruchs zum Testen der Isolierung derartige Leitersegmente aus den folgenden Literaturstellen bekannt:
[39] Youtube-Video "HVC 360 SA In-Line tester for hairpins", heruntergeladen am 23.07.2024 unter https://youtu.be/nVd308TaPzs
[40] Webseite DSE Test Solutions, heruntergeladen am 23.07.2024 unter https://dsetestsolutions.com/e-vehicle-hair-pin

Die Erfindung hat sich zur Aufgabe gestellt, ein hinsichtlich der industriellen Großserienproduktion verbessertes Testen der Isolierung von Leitersegmenten für elektrische Maschinen zu ermöglichen.

Zum Lösen dieser Aufgabe schafft die Erfindung ein Testverfahren nach Anspruch 1. Ein Bereitstellverfahren zum Bereitstellen von Leitersegmenten unter Durchführen eines solchen Testverfahrens sowie eine Testvorrichtung, insbesondere zum Durchführen eines solchen Testverfahrens sind Gegenstand der Nebenansprüche.

Vorteilhafte Ausgestaltungen sind Gegenstand der Unteransprüche.

Die Erfindung schafft ein Verfahren zum Testen einer Isolierung eines Leitersegments für eine elektrische Maschine auf Fehlstellen, mit:
a) elektrisches Verbinden eines Leitersegmentanschlusses des Leitersegments mit einem Testanschluss,
c) relatives Bewegen des Leitersegments und eines Testkontakts, um den zu testenden Bereich der Isolierung mit dem Testkontakt abzufahren und
d) Überprüfen, ob während Schritt c) eine elektrische Verbindung zwischen dem Testanschluss und dem Testkontakt besteht, um so auf eine Fehlstelle der Isolierung zu schließen.

Erfindungsgemäß umfasst das Verfahren weiter den vor oder während Schritt c) durchzuführenden Schritt:
b) kapazitives Aufladen des Leitersegments.

Bei einigen Ausführungsformen umfasst Schritt b) den Schritt:
b1) Anlegen eines elektrischen Feldes in Bewegungsrichtung vor dem Testkontakt.

Bei einigen Ausführungsformen umfasst Schritt b) den Schritt:
b2) Bereitstellen eines in relativer Bewegungsrichtung vor dem Testkontakt angeordneten Potentialausgleichselements und Anlegen einer Spannung zum kapazitiven Aufladen zwischen dem Potentialausgleichselement und dem Testanschluss.

Bei einigen Ausführungsformen ist vorgesehen, dass in Schritt b2) ein Potentialausgleichskontakt zum Kontaktieren des Leitersegments als Potentialausgleichselement bereitgestellt wird und dass Schritt b) weiter den Schritt umfasst:
b3) Abfahren des zu testenden Bereichs der Isolierung mit dem Potentialausgleichskontakt.

Bei einigen Ausführungsformen ist vorgesehen, dass die Spannung zum kapazitiven Aufladen höher ist als eine in Schritt d) zum Testen der elektrischen Verbindung zwischen dem Testanschluss und dem Testkontakt angelegte Testspannung.

Einige Ausführungsformen des Testverfahrens umfassen weiter den Schritt: Bereitstellen eines zu dem Testkontakt gleichartigen Kontaktelements als Potentialausgleichskontakt.

Einige Ausführungsformen des Testverfahrens umfassen weiter den Schritt: Bereitstellen je wenigstens einer Kontaktbürste als Testkontakt und/oder als Potentialausgleichskontakt.

Einige Ausführungsformen des Testverfahrens umfassen weiter den Schritt: Bereitstellen eines länglichen Testkontakts und/oder eines länglichen Potentialausgleichskontakts in relativ zu der Bewegungsrichtung schräg geneigter Anordnung.

Einige Ausführungsformen des Testverfahrens umfassen weiter den Schritt: Bereitstellen des Testkontakts und/oder des Potentialausgleichskontakts mit elektrisch leitfähigen Fasern, wie insbesondere Carbonfasern.

Einige Ausführungsformen des Testverfahrens umfassen weiter den Schritt: relatives Bewegen des an den Testanschluss angeschlossenen Leitersegments relativ zu einer insbesondere als Gehäuse ausgebildeten Halterung, an der in Bewegungsrichtung gesehen zunächst der Potentialausgleichskontakt und dann der Testkontakt angeordnet sind.

Bei einigen Ausführungsformen wird die Isolierung eines Hairpin-Leiters oder eines I-Pin-Leiters für einen Hairpin-Stator einer elektrischen Maschine getestet.

Bei einigen Ausführungsformen wird die Isolierung eines Wellenwicklungsleiters zum Bilden einer Wellenwicklungsmatte getestet.

Bei einigen Ausführungsformen wird die Isolierung einer Wellenwicklungsmatte getestet.

Gemäß einem weiteren Aspekt betrifft die Erfindung ein Verfahren (Bereitstellverfahren) zum Bereitstellen von Leitersegmenten zur Herstellung von Hairpin-Statoren in industrieller Großserienfertigung, umfassend Durchführen eines Testverfahrens nach einer oder mehrerer der voranstehenden Ausgestaltungen nach einem Biegen der Leitersegmente.

Gemäß einem weiteren Aspekt betrifft die Erfindung eine Testvorrichtung zum Testen einer Isolierung eines Leitersegments für eine elektrische Maschine auf Fehlstellen, mit:
einem Testanschluss zum elektrischen Anschließen an einen Leitersegmentanschluss des Leitersegments,
einem Testkontakt zum Abfahren des zu testenden Bereichs der Isolierung;
einer Relativbewegungseinrichtung zum relativen Bewegen des an den Testanschluss angeschlossenen Leitersegments und des Testkontakts, um den zu testenden Bereich der Isolierung mit dem Testkontakt abzufahren,
einer Überprüfungseinrichtung, die zur Überprüfung eingerichtet ist, ob während des Abfahrens der Isolierung durch den Testkontakt eine elektrische Verbindung zwischen dem Testanschluss und dem Testkontakt besteht, um so auf eine Fehlstelle der Isolierung zu schließen, und
einer Aufladeeinrichtung zum kapazitiven Aufladen des Leitersegments vor oder während dem Abfahren durch den Testkontakt.

Bei einigen Ausführungsformen der Testvorrichtung ist vorgesehen, dass die Aufladeeinrichtung zum Anlegen eines elektrischen Feldes in Bewegungsrichtung vor dem Testkontakt eingerichtet ist.

Bei einigen Ausführungsformen der Testvorrichtung ist vorgesehen,
dass die Aufladeeinrichtung ein in relativer Bewegungsrichtung vor dem Testkontakt angeordnetes Potentialausgleichselement aufweist und dazu eingerichtet ist, eine Spannung zum kapazitiven Aufladen zwischen dem Potentialausgleichselement und dem Testanschluss anzulegen.

Bei einigen Ausführungsformen der Testvorrichtung ist vorgesehen,
dass das Potentialausgleichselement einen Potentialausgleichskontakt zum Kontaktieren des Leitersegments aufweist und dass die Testvorrichtung eingerichtet ist, den zu testenden Bereich der Isolierung zunächst mit dem Potentialausgleichskontakt und mit dem Testkontakt abzufahren, wobei insbesondere der Potentialausgleichskontakt voreilend zu dem Testkontakt angeordnet ist.

Bei einigen Ausführungsformen der Testvorrichtung ist vorgesehen,
dass die Testvorrichtung dazu eingerichtet ist, zwischen dem Potentialausgleichselement und dem Testanschluss eine Spannung zum kapazitiven Aufladen anzulegen, die höher ist als eine zum Testen der elektrischen Verbindung zwischen dem Testanschluss und dem Testkontakt angelegte Testspannung.

Bei einigen Ausführungsformen der Testvorrichtung ist vorgesehen,
dass der Potentialausgleichskontakt gleichartig zu dem Testkontakt ausgebildet ist.

Bei einigen Ausführungsformen der Testvorrichtung ist vorgesehen,
dass der Testkontakt und/oder der Potentialausgleichskontakt je wenigstens eine Kontaktbürste aufweist.

Bei einigen Ausführungsformen der Testvorrichtung ist vorgesehen,
dass der Testkontakt und/oder der Potentialausgleichskontakt länglich und relativ zu der Bewegungsrichtung schräg geneigt angeordnet sind.

Bei einigen Ausführungsformen der Testvorrichtung ist vorgesehen,
dass der Testkontakt und/oder der Potentialausgleichskontakt elektrisch leitfähige Carbonfasern aufweisen.

Bei einigen Ausführungsformen der Testvorrichtung ist vorgesehen,
dass eine insbesondere als Gehäuse ausgebildet Halterung vorgesehen ist, an der in relativer Bewegungsrichtung gesehen zunächst der Potentialausgleichskontakt und dann der Testkontakt angeordnet sind.

Einige Ausführungsformen der Testvorrichtung umfassen eine computerimplementierte Steuerung. Insbesondere mithilfe der computerimplementierten Steuerung ist die Testvorrichtung zum Durchführen des Testverfahrens nach einer voranstehend beschriebenen Ausgestaltungen eingerichtet. Die computerimplementierte Steuerung umfasst bei einigen Ausführungsformen einen Prozessor und einen Speicher. Insbesondere ist ein Computerprogramm mit Steueranweisungen in dem Speicher geladen, welche die Testvorrichtung dazu veranlassen, das Testverfahren gemäß einer der obigen Ausgestaltungen durchzuführen.

Ausführungsformen der Erfindung betreffen eine Inline-Leitersegment-Isolierungsprüfung. Insbesondere kann die Isolierung inline, im Zuge der Großserienfertigung einer Spulenwicklung einer elektrischen Maschine geprüft werden. Bei einigen Ausführungsformen können insbesondere Hairpins oder I-Pins oder auch andere Leitersegmente zum Bilden von Spulenwicklungen, wie z.B. Wellenwicklungsdrähte oder auch bereits aus mehreren Leitersegmenten gebildete Leitersegmentanordnungen, wie z.B. Wicklungsmatten auf Fehlstellen in der Isolierung geprüft werden.

Im Folgenden werden einige Vorzüge bevorzugter Ausgestaltungen der Erfindung näher erläutert.

Bei bisher bekannten Testverfahren zum Testen der Isolierung von Leitersegmenten auf Fehlstellen ist die Höchstgeschwindigkeit, bei welcher noch eine sichere Detektion von Fehlstellen gewährleistbar ist, aufgrund des Funktionsprinzips stark limitiert. Beispielsweise ist bei dem aus [39] und [40] bekannten Test eine maximale Fertigungsliniengeschwindigkeit für Hairpins und I-Pins von 500 mm/s bei einer Testspannung von 1500 V und einem Schwellwert von 24µA angegeben.

Ausführungsbeispiele der Erfindung bieten dagegen eine Möglichkeit zur sicheren Prüfung/Detektion bei höheren Geschwindigkeiten. Damit lassen sich kürzere Taktzeiten in der Produktion von Elektromotoren erzielen.

Insbesondere ist bei Ausführungsformen der Erfindung die Höchstgeschwindigkeit, bei welcher noch eine sichere Detektion von Fehlstellen gewährleistet wird, nicht mehr limitiert.

Dadurch lässt sich ein Testen der Isolierung inline während der Großserienproduktion von Spulenwicklungen von elektrischen Maschinen sicher auch bei höheren Geschwindigkeiten durchführen. Somit ist das Testen insbesondere hinsichtlich der Sicherheit auch bei schnellerer Produktion verbessert.

Ein Ausführungsbeispiel wird im Folgenden anhand der beigefügten Zeichnungen näher erläutert. Darin zeigt:
- Fig. 1: eine schematische Seitenansicht einer Testvorrichtung gemäß einem Vergleichsbeispiel bei einem ersten Stadium eines Testverfahrens zum Testen einer Isolierung eines Leitersegments zum Herstellen einer Spulenwicklung einer elektrischen Maschine, gemäß einem Vergleichsbeispiel;
- Fig. 2: eine weitere schematische Seitenansicht der Testvorrichtung gemäß dem Vergleichsbeispiel bei einem weiteren Stadium des Testverfahrens gemäß dem Vergleichsbeispiel;
- Fig. 3: eine Ansicht vergleichbar der Fig. 2 einer Testvorrichtung gemäß einem Ausführungsbeispiel der Erfindung bei einem Stadium eines Testverfahrens gemäß einer Ausführungsform der Erfindung; und
- Fig. 4: eine Ansicht vergleichbar der Fig. 3 wo die Testvorrichtung beim Ausführen eines Testverfahrens gemäß einer weiteren Ausführungsform der Erfindung mit einer anderen Form des Leitersegments gezeigt ist.

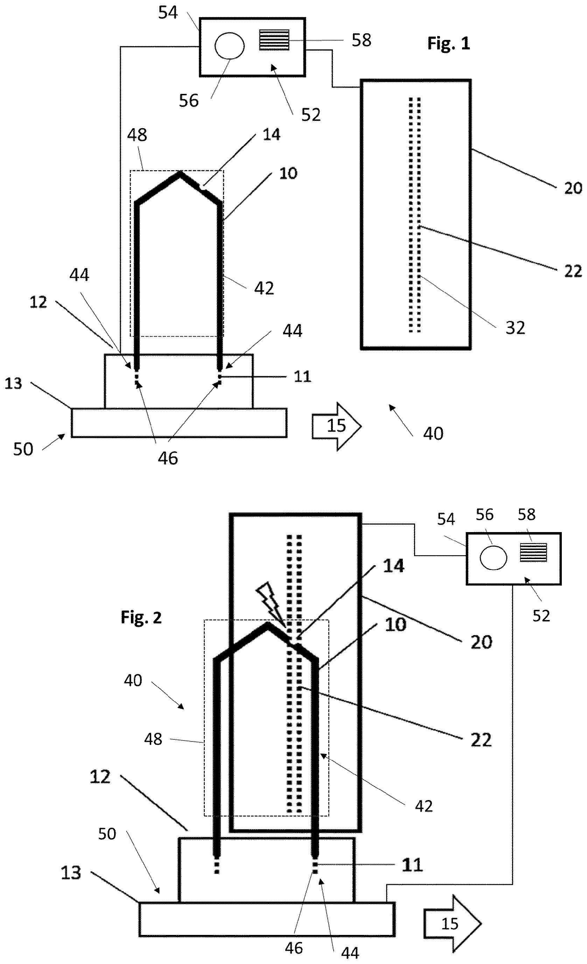

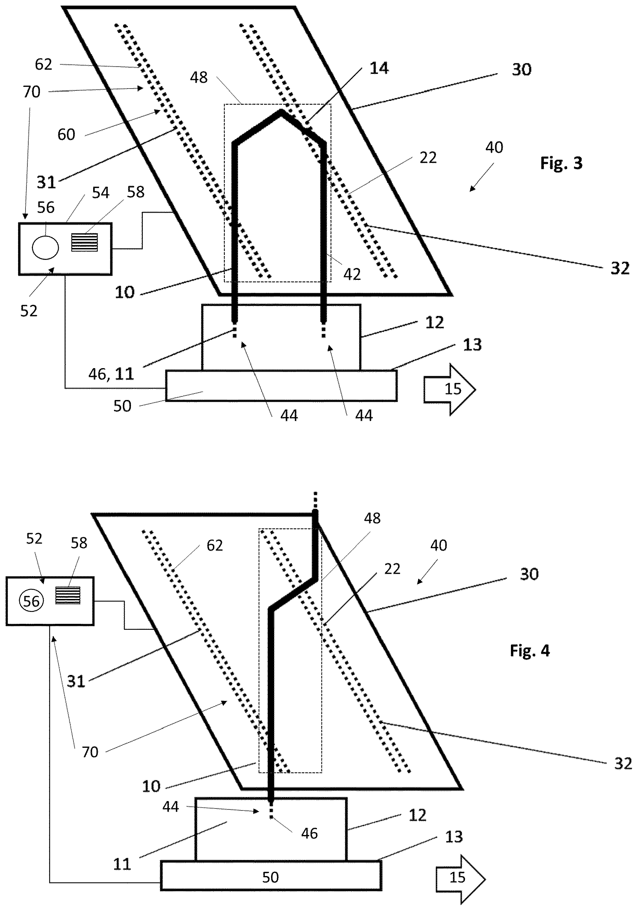

In den Figuren sind jeweils eine Testvorrichtung 40 zum Testen einer Isolierung 42 eines Leitersegments 10 für eine elektrische Maschine auf Fehlstellen 14 beim Ausführen eines Testverfahrens zum Testen der Isolierung des Leitersegments 10 auf Fehlstellen 14 gezeigt, wobei in den Fig. 1 und 2 jeweils eine Testvorrichtung 40 und ein Testverfahren gemäß einem nicht von der Erfindung umfassten Vergleichsbeispiel ähnlich dem Stand der Technik nach [39] oder [40] und in den Fig. 3 und 4 Ausführungsbeispiele für die Testvorrichtung 40 und für das Testverfahren gemäß der Erfindung dargestellt sind. Dabei sind jeweils entsprechende Merkmale mit gleichen Bezugszeichen dargestellt.

Die Testvorrichtung 40 ist jeweils zum Testen einer Isolierung 42 eines Leitersegments 10 für eine elektrische Maschine auf Fehlstellen 14 ausgebildet. Die Testvorrichtung 40 weist einen Testanschluss 44 zum elektrischen Anschließen an einen Leitersegmentanschluss 46 des Leitersegments 10,
einen Testkontakt 32 zum Abfahren des zu testenden Bereichs 48 der Isolierung 42, eine Relativbewegungseinrichtung 50 zum relativen Bewegen des an den Testanschluss 44 angeschlossenen Leitersegments 10 und des Testkontakts 32, um den zu testenden Bereich 48 der Isolierung 42 mit dem Testkontakt 32 abzufahren und eine Überprüfungseinrichtung 52 auf, die zur Überprüfung eingerichtet ist, ob während des Abfahrens der Isolierung 42 durch den Testkontakt 32 eine elektrische Verbindung zwischen dem Testanschluss 44 und dem Testkontakt 32 besteht, um so auf eine Fehlstelle der Isolierung zu schließen,

Die Testvorrichtung 40 ist beispielsweise Teil einer (nicht dargestellten) Herstellanlage zum Herstellen eines Bauteils einer elektrischen Maschine, wie z.B.
einem Stator für Fahrmotoren von E-Fahrzeugen, in industrieller Großserienproduktion. Die Testvorrichtung 40 ist insbesondere Teil einer nicht dargestellten aber aus dem eingangs erwähnten Stand der Technik nach [1] bis [37] bekannten Bereitstelleinrichtung zum Bereitstellen bereits vorgeformter Leitersegmente 10, wie insbesondere bereits gebogener Hairpins von Hairpin-Statoren. Beispielsweise ist die Testvorrichtung 40 in einem Bereich zwischen einer Biegestation zum Biegen der Leitersegmente 10 und einer Spulenwicklungsherstellstation, wo aus den Leitersegmenten 10 eine Spulenwicklung gebildet wird, angeordnet.

Der Leitersegmentanschluss 46 ist je nach zu überprüfenden Leitersegment 10 ausgebildet, beispielsweise weist der Leitersegmentanschluss 46 ein unisoliertes Ende 11 des Leitersegments 10 auf.

Der Testanschluss 44 kann unterschiedlich ausgebildet sein, soweit er die Funktion einer geeigneten elektrischen Verbindung zu dem Leitersegmentanschluss 46 erfüllt. Beispielsweise kann der Testanschluss 44 eine oder mehrere Steckbuchsen, in die ein jeweiliges unisoliertes Ende 11 des Leitersegments 10 eingesteckt wird, oder einen anderen geeigneten Kontakt aufweisen. Bei einigen Ausführungsformen wird das jeweilige Leitersegment 10 bei einem Transport von der Biegestation oder dergleichen Bereitstelleinrichtung zu einer Weiterverarbeitungsstation mittels eines Greifers 12 an einer Transporteinrichtung 13 gegriffen, wobei beim Greifen ein elektrischer Kontakt, z.B. an wenigstens einer Greifbacke des Greifers 12, mit dem unisolierten Ende 11 in Eingriff gebracht wird.

Der Testkontakt 32 kann ebenfalls unterschiedlich ausgebildet sein, soweit er die Funktion eines Abfahrens des zu testenden Bereichs erfüllen kann. Vorteilhaft weist der Testkontakt 32 elektrisch leitende Fasern, insbesondere Carbonfasern auf. Insbesondere weist der Testkontakt 32 eine Kontaktbürste 22 mit einer oder mehrere Reihen von Faserbüscheln auf.

Die Relativbewegungseinrichtung 50 kann ebenfalls unterschiedlich ausgebildet sein, soweit eine Relativbewegung in Relativbewegungsrichtung 15 zwischen dem Leitersegment 10 und dem Testkontakt 32 zum Abfahren des zu testenden Bereichs 48 stattfindet. Bei einigen nicht dargestellten Ausführungsformen ist der Testkontakt 32 beweglich ausgebildet. Bei den dargestellten Beispielen ist die Relativbewegungseinrichtung 50 dazu ausgebildet, das Leitersegment 10 zu bewegen. Beispielsweise weist die Relativbewegungseinrichtung 50 die Transporteinrichtung 13 auf, mittels der die Leitersegmente 10 an Transporteinheiten, beispielsweise Greifern 12, bei an dem Testanschluss 44 angeschlossenen Leitersegmentanschluss 46, an dem Testkontakt 32 vorbei bewegt werden.

Beispielsweise ist der Testkontakt 32 an oder in einem Gehäuse 20, 30 angeordnet, durch das die Leitersegmente 10 hindurch transportiert werden.

Die Überprüfungseinrichtung 50 weist eine Einrichtung zum Erzeugen einer Spannung zwischen dem Testkontakt 32 und dem Testanschluss 44 und eine Einrichtung zum Erfassen eines Stromes zwischen dem Testkontakt 32 und dem Testanschluss 44 auf. Beispielsweise wird eine Gleichspannung im Bereich von 350 V bis 6000 V angelegt. Weiter weist die Überprüfungseinrichtung 50 eine Auswerteeinrichtung auf, die dazu eingerichtet ist, bei Erfassen eines Stromes eine Fehlstelle 14 zu detektieren und ein Signal zum Aussondern des entsprechenden Leitersegments 10 abzugeben. Die Überprüfungseinrichtung 50 ist insbesondere computerimplementiert und kann als gesonderte Einheit oder wie dargestellt als Teil einer computerimplementierten Steuerung 54 zum Steuern der Testvorrichtung 40 ausgebildet sein. Die Steuerung 54 weist einen Prozessor 56 und einen Speicher 58 mit einem darin geladenen Computerprogramm auf, welches die Testvorrichtung 40 veranlasst, das im Folgenden näher erläuterte Testverfahren automatisch durchzuführen.

Zum Testen der Isolierung 42 des Leitersegments 10 für eine elektrische Maschine auf Fehlstellen 14, wird ein Verfahren mit folgenden Schritten durchgeführt:
a) elektrisches Verbinden des Leitersegmentanschlusses 46 des Leitersegments 10 mit dem Testanschluss 44,
c) relatives Bewegen des Leitersegments 10 und des Testkontakts 32, um den zu testenden Bereich 48 der Isolierung 42 mit dem Testkontakt 32 abzufahren und
d) Überprüfen, ob während Schritt c) eine elektrische Verbindung zwischen dem Testanschluss 44 und dem Testkontakt 32 besteht, um so auf eine Fehlstelle 14 der Isolierung 42 zu schließen.

Bei dem Vergleichsbeispiel der Fig. 1 und 2 ist in dem Gehäuse 20 eine einzelne Kontaktbürste 22 zum Bilden des Testkontakts vorgesehen, wobei die Kontaktbürste 22 senkrecht zur Relativbewegungsrichtung 15 angeordnet ist. Es wird beispielsweise eine Spannung von 1500 V angelegt. Damit lässt sich bei niedrigeren Relativbewegungsgeschwindigkeiten relativ gut eine Fehlstelle 14 erkennen. Allerdings ist die Maximalgeschwindigkeit, bei welcher noch eine sichere Detektion von Fehlstellen gewährleistet wird, recht stark begrenzt, so dass das Testen nur bei relativ geringen Taktgeschwindigkeiten stattfinden kann.

Untersuchungen haben ergeben, dass bei höheren Geschwindigkeiten mit dem Testverfahren gemäß dem Vergleichsbeispiel Fehldetektionen entstehen. Ein isoliertes Leitersegment 10 verhält sich kapazitiv. Bei angelegter Spannung fließt unter schneller Geschwindigkeitsänderung des Leitersegments 10 gegenüber der Kontaktbürste 22/Testkontakt 32 ein hoher Strom (kapazitives Verhalten -> Strom ist voreilend), der zur falschen Detektion eines Defekts führen würde, obwohl keine Beschädigung der Isolierung vorliegt.

Bei den in den Fig. 3 und 4 dargestellten und im Folgenden erläuterten Ausführungsformen der Erfindung ist die Höchstgeschwindigkeit, bei welcher noch eine sichere Detektion von Fehlstellen 14 gewährleistet wird, nicht mehr limitiert. Somit bieten Ausführungsformen der Erfindung Möglichkeiten zur sicheren Prüfung/Detektion bei höheren Geschwindigkeiten, so dass kürzere Taktzeiten in der Produktion von Elektromotoren erzielt werden können.

Hierzu weisen Ausführungsformen des erfindungsgemäßen Testverfahrens zusätzlich den vor oder während Schritt c) durchzuführenden Schritt:
b) kapazitives Aufladen des Leitersegments 10
auf.

Bei einigen Ausführungen wird hierzu in Bewegungsrichtung 15 vor dem Testkontakt 32 ein elektrisches Feld angelegt.

Die Testvorrichtung 40 gemäß Ausführungsbeispielen der Erfindung weist zum Durchführen des Testverfahrens eine Aufladeeinrichtung 70 zum kapazitiven Aufladen des Leitersegments 10 vor oder während dem Abfahren durch den Testkontakt 32 auf. Die Aufladeeinrichtung 70 ist insbesondere zum Anlegen eines elektrischen Feldes an dem Leitersegment 10 in Bewegungsrichtung 15 vor dem Testkontakt 32 ausgebildet.

Durch die in den Fig. 3 und 4 gezeigte Testvorrichtung 40 gemäß Ausführungsbeispielen der Erfindung wird hierzu ein Potentialausgleichselement 60 bereitgestellt, das vorzugsweise in Bewegungsrichtung 15 vor dem Testkontakt 32 angeordnet ist. Das Potentialausgleichselement 60 kann unterschiedlich ausgebildet sein, soweit es zum Anlegen des elektrischen Feldes zum kapazitiven Aufladen geeignet ist. Es kann z.B. plattenförmig oder als Leiterbahn ausgebildet sein. Bei den dargestellten Ausführungsformen ist das Potentialausgleichselement 60 gleichartig zu dem Testkontakt 32 ausgebildet. Beispielsweise weist das Potentialausgleichselement 60 einen weiteren Kontakt 31 für den Potentialausgleich - im Folgenden Potentialausgleichskontakt 31 genannt - auf, der insbesondere als weitere Kontaktbürste 62 ausgebildet ist. Der Potentialausgleichskontakt 31 ist beispielsweise in dem Gehäuse 30 in Bewegungsrichtung 15 vor dem Testkontakt 32 angeordnet.

Zum kapazitiven Aufladen wird zwischen dem Potentialausgleichselement 60 und dem Testanschluss 44 eine Spannung angelegt.

Die beiden Kontakte 31 - Potentialausgleichskontakt - und 32 - Testkontakt - sind bei den dargestellten Ausführungen so angeordnet, dass für die unterschiedlichen Geometrien der zu testenden Leitersegmente 10 beim Durchfahren des Gehäuses 30 ein Zustand existiert, während diesem das Leitersegment 10 mit beiden Kontakten 31, 32 zeitgleich in Verbindung steht.

Das Leitersegment 10 wird in kontaktiertem Zustand - unisoliertes Leiterende 11 in Kontakt mit Testanschluss 44, z.B. am Greifer 12 - mit dem Transport - Transporteinrichtung 13 - in das Gehäuse 30 gefahren. Das Gehäuse 30 wird so gestaltet, dass beim Einfahren des Leitersegments 10 ein kapazitives Aufladen stattfindet - z.B. an dem Potentialausgleichskontakt 31 -, um ein fehlerhaftes Detektieren durch das kapazitive Verhalten des Systems, zu umgehen. In einer weiteren Position ist der Testkontakt 32 angebracht, welcher eine Fehlstelle/Defekt an der Isolierung 14 detektiert.

Um das elektrische Feld aufrecht zu erhalten, steht bei den dargestellten Ausführungen das Leitersegment10 für die Detektion einer Fehlstelle 14 beim Einfahren in den Testkontakt 32 noch in Verbindung mit dem Potentialausgleichskontakt 31.

Bei einigen Ausführungsformen sind hierzu der Testkontakt 32 und der Potentialausgleichskontakt 31 länglich und relativ zur Bewegungsrichtung 15 schräg geneigt ausgebildet.

Ein Detektieren von Fehlstellen 14 in der Isolierung 42 bei eigenständigen Leitersegmenten 10 ist geschwindigkeitsunabhängig für alle möglichen Leitersegmentgeometrien möglich und kann somit taktzeitneutral in der Maschine - Herstellanlage - durchgeführt werden. Dies ist gegeben, da die kapazitive Aufladung, die bei Verwendung lediglich des einen Testkontakts 32 wie bei dem Vergleichsbeispiel zur Fehldetektionen bei hohen Geschwindigkeiten führt, bereits durch eine vorangehende Aufladung wie insbesondere durch eine vorangehende Kontaktierung (z.B. mit dem Potentialausgleichskontakt 31) vorweggenommen wird und daher bei Kontaktierung mit dem Testkontakt 32 keine nennenswerte kapazitive Aufladung mehr erfolgt.

Der Potentialausgleichskontakt 31 wird vorzugsweise mit einer etwas erhöhten Spannung (z.B. 2000V) beaufschlagt, sodass während der Zeit bis der Testkontakt 32 erreicht wird, bereits eine Potentialangleichung in dessen Höhe erreicht wurde (z.B. 1500V). Angelegt wird eine Gleichspannung.

Die Kontaktbürsten 22, 62 bestehen vorzugsweise aus elektrisch leitfähigen Carbonfasern. Es sind jedoch auch andere, elektrisch leitfähige Fasern/Bürstenhaare denkbar.

Die Kontaktbürsten 22, 62 werden aufgrund der besseren Kontaktierung und höheren Lebensdauer vorzugsweise pfeilförmig in Durchfahrtrichtung - Bewegungsrichtung 15 - angebracht.

Die in Bewegungsrichtung 15 hinten liegenden Stellen des Leitersegments 10 werden durch die pfeilförmige Anordnung in Durchfahrtrichtung, durch die Eigensteifigkeit der Fasern und durch den aufgrund der hohen Spannung gegebenen Umstand, dass Fehlstellen 14 auch mit gewissem Abstand zur detektierenden Bürste einen elektrischen Durchschlag erzeugen, sicher erkannt.

Fig. 3 zeigt die Durchführung des Testverfahrens zum Testen eines als Hairpin (u-förmig gebogener Leiter) ausgebildeten Leitersegments 10. Wie man Fig. 4 entnehmen kann, können auch andere Leitersegmentformen, wie z.B. wie dargestellt I-Pins oder auch wellenartig gebogene Leitersegmente (für Wellenwicklungen) getestet werden. Mit dem Testprinzip können somit auch andere Leitergeometrien sicher und mit hoher Taktzeit getestet werden.

Wenngleich in den Figuren jeweils nur eine Seite des jeweiligen Gehäuses 20, 30 mit einer Kontaktbürste 22, 62 zum Abfahren einer Seite des Leitersegments 10 gezeigt ist, sollte klar sein, dass die Bürsten der Kontaktbürsten von gegenüberliegenden Seiten auf das Leitersegment 10 zu gerichtet sein können, um die vollständige Oberfläche des zu testenden Bereichs 48 des Leitersegments abzufahren.

Die Erfindung betrifft ein Verfahren zum Testen einer Isolierung (42) eines Leitersegments (10) für eine elektrische Maschine auf Fehlstellen, mit:
a) elektrisches Verbinden eines Leitersegmentanschlusses (46) des Leitersegments (10) mit einem Testanschluss (44),
c) relatives Bewegen des Leitersegments (10) und eines Testkontakts (32), um den zu testenden Bereich (48) der Isolierung (42) mit dem Testkontakt (32) abzufahren und
d) Überprüfen, ob während Schritt c) eine elektrische Verbindung zwischen dem Testanschluss (44) und dem Testkontakt (32) besteht, um so auf eine Fehlstelle (14) der Isolierung (42) zu schließen.

Um Fehlstellen (14) auch bei höheren Geschwindigkeiten sicher zu erfassen und Fehldetektionen zu verringern oder zu vermeiden, weist das Verfahren weiter den vor oder während Schritt c) durchzuführenden Schritt:
b) (gezieltes) kapazitives Aufladen des Leitersegments (10)
auf.

### Bezugszeichenliste:

- 10: Leitersegment
- 11: unisoliertes Ende des Leitersegments
- 12: Greifer und/oder Kontakt
- 13: Transporteinrichtung
- 14: Fehlstelle, z.B. Defekt, an Isolierung
- 15: Relativbewegungsrichtung
- 20: Gehäuse für Kontaktbürste oder ähnliches (Testkontakt)
- 22: einzelne Kontaktbürste
- 30: Gehäuse für Kontaktbürste oder ähnliches
- 31: Potentialausgleichskontakt
- 32: Testkontakt
- 40: Testvorrichtung
- 42: Isolierung
- 44: Testanschluss
- 46: Leitersegmentanschluss
- 48: zu testender Bereich
- 50: Relativbewegungseinrichtung
- 52: Überprüfungseinrichtung
- 54: Steuerung
- 56: Prozessor
- 58: Speicher
- 60: Potentialausgleichselement
- 62: Kontaktbürste
- 70: Aufladeeinrichtung

## Patentansprüche

1. Verfahren zum Testen einer Isolierung (42) eines Leitersegments (10) für eine elektrische Maschine auf Fehlstellen, mit:
a) elektrisches Verbinden eines Leitersegmentanschlusses (46) des Leitersegments (10) mit einem Testanschluss (44),
c) relatives Bewegen des Leitersegments (10) und eines Testkontakts (32), um den zu testenden Bereich (48) der Isolierung (42) mit dem Testkontakt (32) abzufahren und
d) Überprüfen, ob während Schritt c) eine elektrische Verbindung zwischen dem Testanschluss (44) und dem Testkontakt (32) besteht, um so auf eine Fehlstelle (14) der Isolierung (42) zu schließen,
**gekennzeichnet durch** den vor oder während Schritt c) durchzuführenden Schritt: b) kapazitives Aufladen des Leitersegments (10).

2. Verfahren nach Anspruch 1, **dadurch gekennzeichnet,**
**dass** Schritt b) umfasst:
b1) Anlegen eines elektrischen Feldes in Bewegungsrichtung vor dem Testkontakt (32).

3. Verfahren nach einem der voranstehenden Ansprüche, **dadurch gekennzeichnet,**
**dass** Schritt b) umfasst:
b2) Bereitstellen eines in relativer Bewegungsrichtung vor dem Testkontakt (32) angeordneten Potentialausgleichselements (60) und Anlegen einer Spannung zum kapazitiven Aufladen zwischen dem Potentialausgleichselement (60) und dem Testanschluss (32).

4. Verfahren nach Anspruch 3, **dadurch gekennzeichnet,**
**dass** in Schritt b2) ein Potentialausgleichskontakt (31) zum Kontaktieren des Leitersegments (10) als Potentialausgleichselement (60) bereitgestellt wird und dass Schritt b) weiter den Schritt umfasst:
b3) Abfahren des zu testenden Bereichs (48) der Isolierung (42) mit dem Potentialausgleichskontakt (31).

5. Verfahren nach einem der Ansprüche 3 oder 4, **dadurch gekennzeichnet, dass** die Spannung zum kapazitiven Aufladen höher ist als eine in Schritt d) zum Testen der elektrischen Verbindung zwischen dem Testanschluss (44) und dem Testkontakt (32) angelegte Testspannung.

6. Verfahren nach einem der Ansprüche 3 bis 5, **gekennzeichnet durch** wenigstens einen oder mehrere der Schritte,
6.1 Bereitstellen eines zu dem Testkontakt (32) gleichartigen Kontaktelements als Potentialausgleichskontakt (31);
6.2 Bereitstellen je wenigstens einer Kontaktbürste (22, 62) als Testkontakt (32) und/oder als Potentialausgleichskontakt (31);
6.3 Bereitstellen eines länglichen Testkontakts (32) und/oder eines länglichen Potentialausgleichskontakts (31) in relativ zu der Bewegungsrichtung schräg geneigter Anordnung;
6.4 Bereitstellen des Testkontakts (32) und/oder des Potentialausgleichskontakts (31) mit elektrisch leitfähigen Carbonfasern;
6.5 relatives Bewegen des an den Testanschluss (44) angeschlossenen Leitersegments (10) relativ zu einer insbesondere als Gehäuse (30) ausgebildeten Halterung, an der in Bewegungsrichtung gesehen zunächst der Potentialausgleichskontakt (31) und dann der Testkontakt (32) angeordnet sind.

7. Verfahren nach einem der voranstehenden Ansprüche, **dadurch gekennzeichnet**,
7.1 dass die Isolierung (42) eines Hairpin-Leiters oder eines I-Pin-Leiters für einen Hairpin-Stator einer elektrischen Maschine getestet wird oder
7.2 dass die Isolierung (42) eines Wellenwicklungsleiters zum Bilden einer Wellenwicklungsmatte getestet wird oder
7.3 dass die Isolierung einer Wellenwicklungsmatte getestet wird.

8. Verfahren zum Bereitstellen von Leitersegmenten (10) zur Herstellung von Hairpin-Statoren in industrieller Großserienfertigung, umfassend Durchführen eines Testverfahrens nach einem der voranstehenden Ansprüche nach einem Biegen der Leitersegmente (10).

9. Testvorrichtung (40) zum Testen einer Isolierung eines Leitersegments (10) für eine elektrische Maschine auf Fehlstellen (14), mit:
einem Testanschluss (44) zum elektrischen Anschließen an einen Leitersegmentanschluss (46) des Leitersegments (10),
einem Testkontakt (32) zum Abfahren des zu testenden Bereichs (48) der Isolierung (42);
einer Relativbewegungseinrichtung (50) zum relativen Bewegen des an den Testanschluss (44) angeschlossenen Leitersegments (10) und des Testkontakts (32), um den zu testenden Bereich (48) der Isolierung (42) mit dem Testkontakt (32) abzufahren und
einer Überprüfungseinrichtung (52), die zur Überprüfung eingerichtet ist, ob während des Abfahrens der Isolierung (42) durch den Testkontakt (32) eine elektrische Verbindung zwischen dem Testanschluss (44) und dem Testkontakt (32) besteht, um so auf eine Fehlstelle (14) der Isolierung zu schließen, **gekennzeichnet durch**
eine Aufladeeinrichtung (70) zum kapazitiven Aufladen des Leitersegments (10) vor oder während dem Abfahren **durch** den Testkontakt (32).

10. Testvorrichtung (40) nach Anspruch 9, **dadurch gekennzeichnet,**
**dass** die Aufladeeinrichtung (70) zum Anlegen eines elektrischen Feldes in Bewegungsrichtung vor dem Testkontakt (32) eingerichtet ist.

11. Testvorrichtung (40) nach Anspruch 9 oder nach Anspruch 10, **dadurch gekennzeichnet,**
**dass** die Aufladeeinrichtung (70) ein in relativer Bewegungsrichtung vor dem Testkontakt (32) angeordnetes Potentialausgleichselement (60) aufweist und dazu eingerichtet ist, eine Spannung zum kapazitiven Aufladen zwischen dem Potentialausgleichselement (60) und dem Testanschluss (44) anzulegen.

12. Testvorrichtung (40) nach Anspruch 11, **dadurch gekennzeichnet,**
**dass** das Potentialausgleichselement (60) einen Potentialausgleichskontakt (31) zum Kontaktieren des Leitersegments (10) aufweist und dass die Testvorrichtung (40) eingerichtet ist, den zu testenden Bereich (48) der Isolierung (42) mit dem Potentialausgleichskontakt (31) und mit dem Testkontakt (32) abzufahren, wobei insbesondere der Potentialausgleichskontakt (31) voreilend zu dem Testkontakt (32) angeordnet ist.

13. Testvorrichtung (40) nach einem der Ansprüche 11 oder 12, **dadurch gekennzeichnet,**
**dass** die Testvorrichtung (40) dazu eingerichtet ist, zwischen dem Potentialausgleichselement (60) und dem Testanschluss (44) eine Spannung zum kapazitiven Aufladen anzulegen, die höher ist als eine zum Testen der elektrischen Verbindung zwischen dem Testanschluss (44) und dem Testkontakt (32) angelegte Testspannung.

14. Testvorrichtung (40) nach einem der Ansprüche 11 bis 13, **gekennzeichnet durch** wenigstens eines oder mehrere der folgenden Merkmale,
14.1 dass der Potentialausgleichskontakt (31) gleichartig zu dem Testkontakt (32) ausgebildet ist;
14.2 dass der Testkontakt (32) und/oder der Potentialausgleichskontakt (31) je wenigstens eine Kontaktbürste (22, 62) aufweist;
14.3 dass der Testkontakt (32) und/oder der Potentialausgleichskontakt (31) länglich und relativ zu der Bewegungsrichtung schräg geneigt angeordnet sind;
14.4 dass der Testkontakt (32) und/oder der Potentialausgleichskontakt (31) elektrisch leitfähige Carbonfasern aufweisen;
14.5 dass eine insbesondere als Gehäuse (30) ausgebildete Halterung vorgesehen ist, an der in relativer Bewegungsrichtung gesehen zunächst der Potentialausgleichskontakt (31) und dann der Testkontakt (32) angeordnet sind.

15. Testvorrichtung (40) nach einem der Ansprüche 9 bis 14, umfassend eine computerimplementierte Steuerung (54), wobei die Testvorrichtung (40) zum Durchführen des Verfahrens nach einem der Ansprüche 1 bis 7 eingerichtet ist.
